# EUROPEAN PATENT APPLICATION

(11) **EP 4 580 029 A1**
(43) Date of publication of application: **02.07.2025**
(21) Application number: 23857444.6
(22) Date of filing: 25.08.2023
(51) Int. Cl.: H02M 7/48, G01K 1/14

(54) **TEMPERATURE SENSOR MODULE AND ELECTRONIC DEVICE USING SAME**

(30) Priority: 26.08.2022 JP 2022135105; 08.08.2023 JP 2023129552; 23.08.2023 JP 2023135642
(71) Applicant: DENSO CORPORATION, Kariya-city, Aichi 448-8661 (JP)
(72) Inventor: FUJISAWA Kazuaki, Kariya-city, Aichi 4488661 (JP); NAKAKUKI Ippei, Kariya-city, Aichi 4488661 (JP); YAMAUCHI Kentaro, Kariya-city, Aichi 4488661 (JP); SUZUKI Toshiro, Kariya-city, Aichi 4488661 (JP)
(74) Representative: Kuhnen & Wacker Patent- und Rechtsanwaltsbüro PartG mbB
(86) International application number: PCT/JP2023/030741
(87) International publication number: WO 2024/043336

(57) **Abstract**

A temperature sensor module includes a temperature sensor (320) that outputs a detection signal corresponding to a temperature. The module has a mounting portion (370) on which the temperature sensor (320) is mounted. The module has a sealing member (340) encapsulates the temperature sensor (320) and the mounting portion (370). The module also includes a heat-conductive member (371) that is thermally connected to the temperature sensor (320) and is made of a material with higher thermal conductivity than the sealing member (340). The heat-conductive member (371) is arranged within the sealing member (340) so that a portion of the heat-conductive member (371) is exposed from the sealing member (340). The heat-conductive member (371) is designed to be in contact with a part to be measured.

## Description

### CROSS-REFERENCE TO RELATED APPLICATIONS

This application is based on Japanese Patent Application No. 2022-135105 filed on August 26, 2022, Japanese Patent Application No. 2023-129552 filed on August 08, 2023, and Japanese Patent Application No. 2023-135642 filed on August 23, 2023, the contents of which are incorporated herein by reference.

### TECHNICAL FIELD

The present disclosure relates to a temperature sensor module and an electronic device using the temperature sensor module.

### BACKGROUND

A temperature sensor module with a temperature sensor has been proposed (see, for example, Non-Patent Literature 1). More specifically, the temperature sensor module has a configuration that includes a temperature sensor mounted on a substrate, and the substrate and the temperature sensor are sealed in a sealing member made of resin.

### PRIOR ART LITERATURE

### NON-PATENT LITERATURE

Non-Patent Literature 1: Jun Sakata, Card Type Temperature Detector, Toyota Technical Publication, February 28, 2022, Publication No. 33549.

### SUMMARY OF THE INVENTION

By the way, the inventors are considering configuring an electronic device by placing a semiconductor module, in which heat-generating elements are placed on a substrate and sealed with a sealing member, in a cooling device, and also by placing the above temperature sensor module in the cooling device. More specifically, the cooling device is configured with a flow path through which a cooling medium such as cooling water passes so that the semiconductor module can be cooled. The semiconductor module and the temperature sensor module are then placed in contact with the cooling device. The temperature sensor located in the temperature sensor module outputs a detection signal corresponding to a temperature of the cooling medium.

However, in such electronic devices, the inventors have found that detection accuracy of the temperature sensor may decrease depending on the configuration of the temperature sensor module.

The object of the present disclosure is to provide a temperature sensor module and an electronic device using the temperature sensor module, which is capable of reducing a decrease in detection accuracy of the temperature sensor.

According to one aspect of the present disclosure, a temperature sensor module includes a temperature sensor that outputs a detection signal corresponding to a temperature. The module has a mounting portion where the temperature sensor is mounted. A sealing member encapsulates the temperature sensor and the mounting portion. Additionally, the module includes a heat-conductive member that is thermally connected to the temperature sensor and made of a material with higher thermal conductivity than the sealing member. The heat-conductive member is arranged within the sealing member so that a part of the heat-conductive member is exposed from the sealing member. The heat-conductive member is designed to be in contact with a part to be measured.

According to this, the temperature sensor module is used in such a way that the heat-conductive member is in contact with the part to be measured. As a result, the temperature of the part to be measured can be more easily transferred to the temperature sensor via the heat-conductive member, thereby improving the detection accuracy.

According to another aspect of the present disclosure, an electronic device includes a semiconductor module that has a heat-generating element generating heat when an electric current flows through it. The device also has a cooling device with a flow path for a cooling medium to cool the semiconductor module. Additionally, the device includes a temperature sensor module. The cooling device has an inlet pipe for the cooling medium to flow in and an outlet pipe for the cooling medium to flow out. A connecting pipe connects the inlet pipe to the outlet pipe. The semiconductor module is in contact with the connecting pipe. The heat-conductive member of the temperature sensor module is in contact with the connecting pipe.

According to this, the temperature sensor module is positioned so that the heat-conductive member is in contact with the connecting pipe. As a result, the temperature of the cooling medium can be more easily transferred to the temperature sensor via the heat-conductive member, thereby improving the detection accuracy.

The reference numerals in parentheses attached to the components and the like indicate an example of correspondence between the components and the like and specific components and the like described in an embodiment to be described below.

### BRIEF DESCRIPTION OF DRAWINGS

FIG. 1 is a circuit diagram of an electronic device according to a first embodiment.
FIG. 2 is a front view of the electronic device according to the first embodiment.
FIG. 3 is a plan view of the temperature sensor module viewed from a direction of arrow III in FIG. 2.
FIG. 4 is a schematic diagram omitting a sealing member in FIG. 3.
FIG. 5 is a diagram illustrating a relationship between a temperature of cooling water and a temperature detected by a temperature sensor.
FIG. 6 is a schematic diagram of a temperature sensor module according to a second embodiment.
FIG. 7 is a schematic diagram of a temperature sensor module according to a third embodiment.
FIG. 8 is a plan view of a temperature sensor module according to a fourth embodiment.
FIG. 9 is a plan view of the temperature sensor module according to the fourth embodiment.
FIG. 10 is a plan view of the temperature sensor module according to the fourth embodiment.
FIG. 11 is a cross-sectional view taken along a line XI-XI shown in FIG. 10.
FIG. 12 is a front view of an electronic device according to the fourth embodiment.
FIG. 13 is a front view of an electronic device according to a fifth embodiment.
FIG. 14 is a cross-sectional view of a temperature sensor module according to a sixth embodiment.
FIG. 15 is a front view of an electronic device in another embodiment.
FIG. 16 is a front view of an electronic device in another embodiment.

### DETAILED DESCRIPTION

Hereinafter, embodiments of the present disclosure will be described with reference to the drawings. In each of the following embodiments, parts that are identical or equivalent to each other are denoted with the same reference numerals.

### First Embodiment

An electronic device according to a first embodiment will be described with reference to the drawings. In the following, a power converter as the electronic device will be used as an example. Such electronic devices are also suitable for use in vehicles, for example.

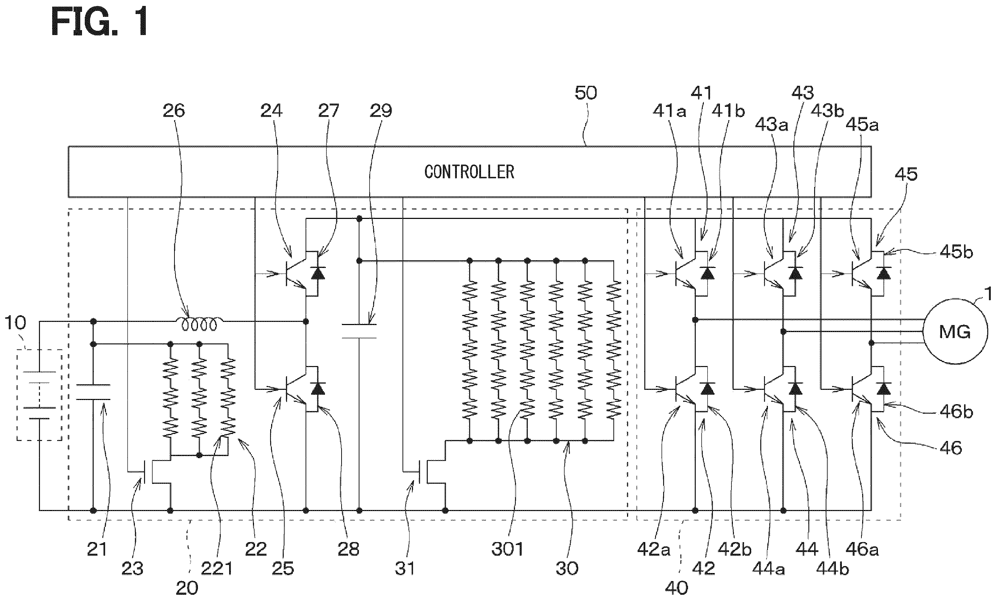

First, a circuit configuration of the electronic device of the present embodiment will be described. As shown in FIG. 1, the electronic device of the present embodiment is configured to drive a three-phase motor as load 1 and includes a power supply 10, a booster circuit 20, an inverter circuit 40, and a controller 50.

The power supply 10 is constructed from a battery and other components installed in the vehicle, and supplies direct current voltage.

The booster circuit 20 includes a first capacitor 21, a first discharge resistor 22, a first discharge switching element 23, a first boost switching element 24, and a second boost switching element 25. The booster circuit 20 includes a coil 26, a first diode element 27, a second diode element 28, a second capacitor 29, a second discharge resistor 30, and a second discharge switching element 31.

The first capacitor 21 smoothes a voltage supplied by the power supply 10 and is located between the high and low potential sides of the power supply 10.

The first discharge resistor 22 of the present embodiment has chip resistors 221 connected in series and the chip resistors connected in series are connected in parallel. The first discharge resistor 22 is connected in parallel with the first capacitor 21 and forms a circuit for discharging the charge of the first capacitor 21. The first discharge switching element 23 is composed of, for example, a MOSFET (Metal Oxide Semiconductor Field Effect Transistor), and is arranged between the first discharge resistor 22 and the low potential side of the power supply 10 to increase the discharge rate of the charge in the first capacitor 21. The first discharge switching element 23 is connected to the controller 50 and is controlled on and off by the controller 50.

The first boost switching element 24 and the second boost switching element 25 are composed of, for example, MOSFETs and are connected in series. The high potential side of the power supply 10 is connected to a midpoint between the first boost switching element 24 and the second boost switching element 25 via the coil 26, and the low potential side of the second boost switching element 25 is connected to the low potential side of the power supply 10. In the present embodiment, the first diode element 27 and the second diode element 28 for return current are connected in parallel to the first boost switching element 24 and the second boost switching element 25, respectively. The voltage supplied by the power supply 10 is boosted by switching the first boost switching element 24 and the second boost switching element 25 on and off by the controller 50 described below.

The second capacitor 29 is connected in parallel with the first boost switching element 24 and the second boost switching element 25 to smooth the boosted voltage.

The second discharge resistor 30, like the first discharge resistor 22, consists of chip resistors 301 connected in series and in parallel. The second discharge resistor 30 is connected in parallel with the second capacitor 29 and forms a circuit for discharging the charge of the second capacitor 29. The second discharge switching element 31 is composed of, for example, a MOSFET and is placed between the second discharge resistor 30 and the low potential side of the power supply 10 to increase the discharge speed of the charge of the second capacitor 29. The second discharge switching element 31 is connected to the controller 50 and is controlled on and off by the controller 50.

The inverter circuit 40 of the present embodiment has a three-phase inverter circuit in which series-connected upper and lower arms 41 to 46 are connected in parallel for three phases. In the inverter circuit 40, intermediate potentials between the upper arms 41, 43, 45 and the lower arms 42, 44, 46 are applied in an orderly manner and alternately to a U-phase, a V-phase and a W-phase of the three-phase motor as the load 1.

More specifically, the upper and lower arms 41 to 46 are configured with switching elements 41a to 46a, such as IGBTs (Insulated Gate Bipolar Transistor) and MOSFETs, and diode elements 41b to 46b for return current, respectively. The three-phase inverter circuit 40 is connected to the controller 50, and the switching elements 41a to 46a in the upper and lower arms 41 to 46 of each phase are switched on and off to supply three-phase alternating current of different periods to the load 1. Each switching element 41a to 46a and each diode element 41b to 46b are connected in parallel. In the present embodiment, each switching element 41a to 46a corresponds to a heat-generating element that generates heat when a predetermined electric current flows through it.

The controller 50 is composed of a vehicle ECU (Electronic Control Unit) or the like, and is equipped with a CPU (not shown in the figure) and various storage units such as ROM, RAM, and nonvolatile RAM. The controller 50 realizes various control operations by the CPU reading and executing various data from the storage units. The ROM or the non-volatile RAM stores in advance various data (for example, initial values, look-up tables, maps, and the like) used when the programs are executed. CPU is an abbreviation for Central Processing Unit, ROM is an abbreviation for Read Only Memory, and RAM is an abbreviation for Random Access Memory. A storage medium such as the ROM is a non-transitory tangible storage medium.

More specifically, the controller 50 is connected to the booster circuit 20 and the inverter circuit 40 and controls each switching element 23, 24, 25, 31, 41a to 46a on and off. The controller 50 receives a detection signal from the temperature sensor 320 according to a temperature of the cooling medium, as specifically described below. The controller 50 then determines abnormality of the cooling device 200 based on the detection signal.

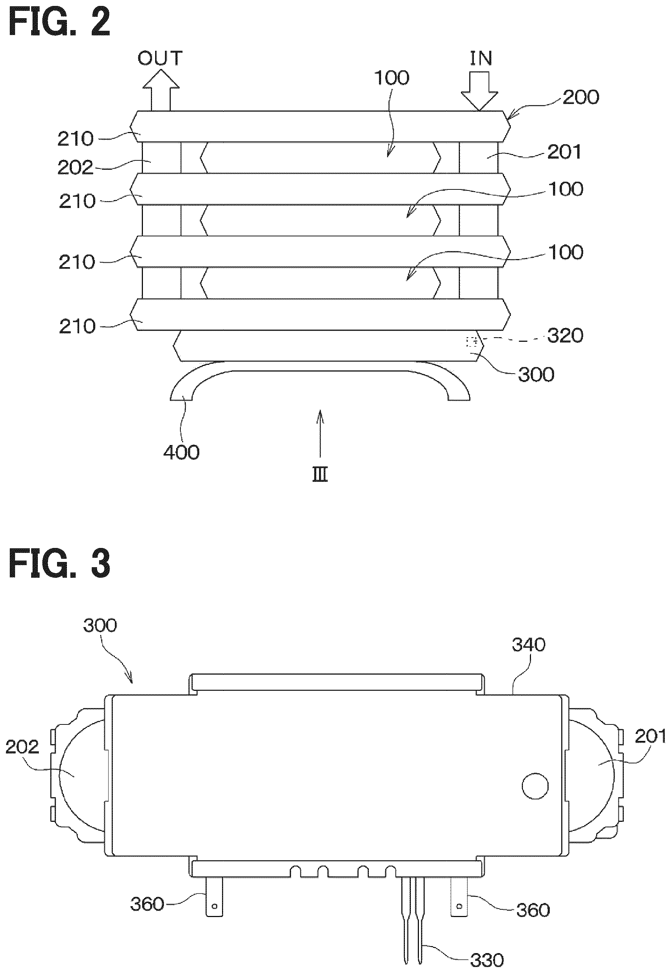

First, a configuration of the electronic device of the present embodiment will be described. As shown in FIG. 2, the electronic device has a semiconductor module 100 for configuring the inverter circuit 40, the cooling device 200 for cooling the semiconductor module 100, and a temperature sensor module 300 for detecting the temperature of the cooling medium flowing through the cooling device 200. Although a circuit configuration regarding the temperature sensor module 300 is omitted in FIG. 1, the temperature sensor module 300 is also connected to the controller 50. The electronic device also has a first capacitor 21, a first discharge resistor 22, a first discharge switching element 23, a first boost switching element 24, a second boost switching element 25, located in a different position from FIG. 2. The electronic device also has a coil 26, a first diode element 27, a second diode element 28, a second capacitor 29, a second discharge resistor 30, and a second discharge switching element 31, which are located in different positions than in FIG. 2.

The semiconductor module 100 is configured by modularizing one upper arm 41, 43, 45 of each layer and one lower arm 42, 44, 45 of each layer in the inverter circuit 40 in the present embodiment. And in the present embodiment, three semiconductor modules 100 are provided to configure the inverter circuit 40 with U, V, and W phases.

The cooling device 200 flows the cooling medium such as the cooling water inside, and is equipped with an inlet pipe 201 and an outlet pipe 202, which constitute a circular flow path, and a connecting pipe 210, which is connected to the inlet pipe 201 and the outlet pipe 202 and constitutes an abbreviated rectangular flow path. More specifically, the inlet pipe 201 and the outlet pipe 202 are arranged to extend in the same direction. The connecting pipe 210 is rectangular in plan with one direction as a longitudinal direction. In addition, the connecting pipe 210 is arranged in multiple locations along an arrangement direction in which the inlet pipe 201 and the outlet pipe 202 extend, with the inlet pipe 201 and the outlet pipe 202 passing through ends of the connecting pipe 210 in the longitudinal direction. The inlet pipe 201 and the outlet pipe 202 are inserted into both ends of the connecting pipe 210. Multiple connecting pipes 210 are arranged with a gap in the arrangement direction. Four connecting pipes 210 of the present embodiment are provided so that three gaps are configured along the arrangement direction. One connecting pipe 210, which is an outermost in the arrangement direction (i.e., a bottom 210 in FIG. 2), is closed on a side opposite a side equipped with the inlet pipe 201 and the outlet pipe 202.

The cooling device 200 in this configuration cools each part installed in contact with the cooling device 200 by the cooling medium such as the cooling water flowing in from the inlet pipe 201 and out from the outlet pipe 202 via the connecting pipe 210. Although details are omitted from the cooling device 200, the cooling medium discharged from the outlet pipe 202 flows into the inlet pipe 201 via a radiator or the like. In other words, the cooling device 200 allows the cooling medium to circulate. In FIG. 2, the arrangement direction is an up-down direction.

The semiconductor module 100 is positioned between adjacent the connecting pipes 210 along the arrangement direction and in contact with the connecting pipes 210. Each semiconductor module 100 is thereby cooled by the cooling device 200.

The temperature sensor module 300 is provided to be in contact with the outermost connecting pipe 210 along the arrangement direction. In the present embodiment, the temperature sensor module 300 is positioned so that it is in contact with the connecting pipe 210, which is located at the bottom of FIG. 2, and is pressed toward the connecting pipe 210 by an elastic member 400 such as a spring. By pressing the temperature sensor module 300 toward the connecting pipe 210 by the elastic member 400 in this manner, the formation of a gap between the semiconductor module 100 and the connecting pipe 210 can be reduced.

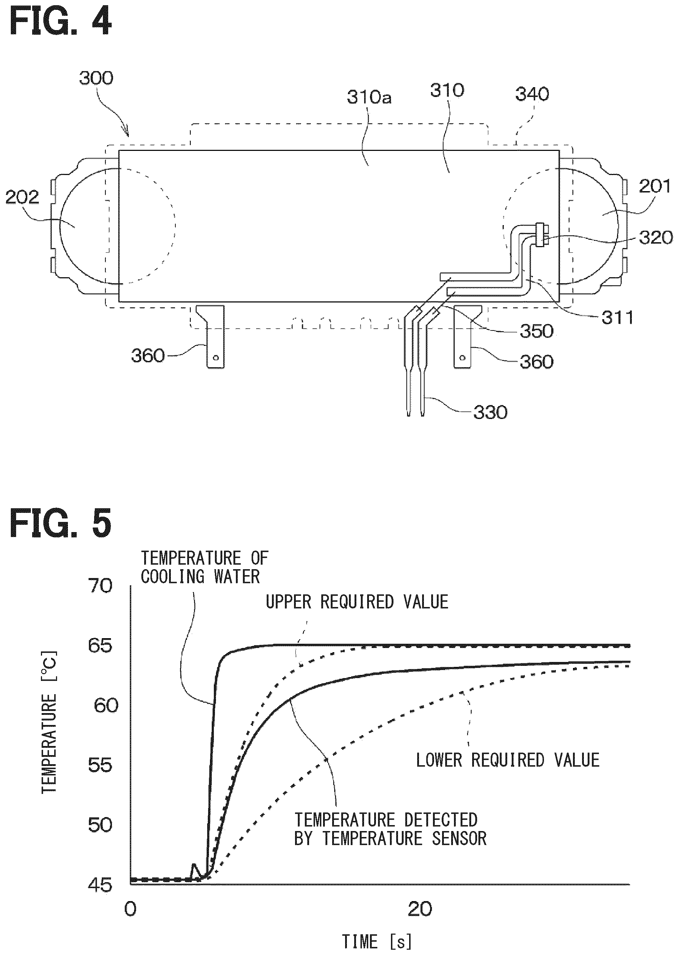

Hereinafter, a configuration of the temperature sensor module 300 of the present embodiment will be described with reference to FIGS. 3, 4. The temperature sensor module 300 has a printed circuit board 310, the temperature sensor 320, a terminal 330, and a sealing member 340. FIG. 4 shows the sealing member 340 in FIG. 3 as a dotted line, and a portion located within the sealing member 340 as a solid line.

The printed circuit board 310 has a single surface 310a and a wiring pattern 311 is formed on the single surface 310a. The temperature sensor 320 is composed of a thermistor or the like and is arranged to be connected to the wiring pattern 311 formed on the single surface 310a of the printed circuit board 310. The temperature sensor 320 of the present embodiment is positioned opposite the inlet pipe 201 when installed in the cooling device 200.

The terminal 330 is rod-shaped and is located around the printed circuit board 310, with one end side electrically connected to the wiring pattern 311 via a bonding wire 350.

The sealing member 340 is made of epoxy resin or the like with low thermal conductivity, and is arranged to integrally seal the printed circuit board 310 and the temperature sensor 320 while exposing the other end side of the terminal 330.

The temperature sensor module 300 of the present embodiment is also equipped with a positioning portion 360 used for positioning the temperature sensor module 300. The positioning portion 360 of the present embodiment is provided in two pieces so as to sandwich the terminal 330, and is integrated with the terminal 330 by the sealing member 340.

The temperature sensor module 300 is then positioned to be in contact with the outermost connecting pipe 210 along the arrangement direction, as described above. In this case, the temperature sensor module 300 is positioned so that the temperature sensor 320 is located on the side of the inlet pipe 201 rather than a center between the inlet pipe 201 and the outlet pipe 202. In other words, the temperature sensor 320 is positioned on the printed circuit board 310 so that when the temperature sensor module 300 is positioned in contact with the connecting pipe 210, it is positioned closer to the inlet pipe 201 than the center between the inlet pipe 201 and the outlet pipe 202. In the present embodiment, the temperature sensor 320 is located on the printed circuit board 310 opposite the inlet pipe 201. In other words, the temperature sensor 320 is positioned overlapping the inlet pipe 201 in a normal direction of the printed circuit board 310.

The electronic device according to the present embodiment has been described in terms of its configuration. The electronic device then supplies three-phase alternating current to the load 1 while cooling the semiconductor module 100 by flowing the cooling medium through the cooling device 200. The temperature sensor module 300 outputs detection signals corresponding to the temperature of the cooling medium from the temperature sensor 320 to the controller 50. The controller 50 then determines the abnormality of the cooling device 200 based on the detection signal.

In this case, the temperature sensor 320 is positioned on the side of the inlet pipe 201 rather than the center between the inlet pipe 201 and the outlet pipe 202. As a result, detecting the temperature of the cooling medium before it is affected by the temperature of the semiconductor module 100 with heat-generating elements becomes easier, thereby improving the detection accuracy with respect to the cooling medium. The temperature sensor 320 is positioned opposite the inlet pipe 201, which further improves the detection accuracy.

Here, the inventors' study has yielded results shown in FIG. 5 regarding a relationship between time and temperature when the temperature sensor 320 is placed opposite the inlet pipe 201. In the electronic device in which the semiconductor module 100 is placed in the cooling device 200 as described above, the detection result for the temperature change of the cooling medium is currently required to be included between am upper and lower required values, as shown in FIG. 5. It is then confirmed that the current requirements can be adequately met by placing the temperature sensor 320 opposite the inlet pipe 201, as in the present embodiment. FIG. 5 shows the simulation results when the cooling water as the cooling medium is allowed to circulate in the cooling device 200.

In the present embodiment described above, the temperature sensor module 300 is arranged such that the temperature sensor 320 is located between the inlet pipe 201 and a midpoint of the inlet pipe 201 and the outlet pipe 202. As a result, it becomes easier to detect the temperature of the cooling medium before it is affected by the temperature of the semiconductor module 100, thereby improving detection accuracy.

In the present embodiment, the temperature sensor 320 is positioned opposite the inlet pipe 201. As a result, detecting the temperature of the cooling medium before it is further affected by the temperature of the semiconductor module 100 is facilitated, thereby further improving detection accuracy.

### Second Embodiment

A second embodiment will be described. The second embodiment adds a temperature sensor 320 to the first embodiment. Other configurations are the same as those in the first embodiment, and thus, description thereof will be omitted here.

First, as described above, a temperature sensor module has been proposed, which includes a temperature sensor placed on a substrate and the substrate and temperature sensor sealed in a sealing member made of resin (see, for example, Non-Patent Literature 1).

By the way, the inventors are considering configuring an electronic device by placing a semiconductor module, in which heat-generating elements are placed on a substrate and sealed with a sealing member, in a cooling device, and also by placing the above temperature sensor module in the cooling device. More specifically, the cooling device is configured with a flow path through which a cooling medium such as cooling water passes so that the semiconductor module can be cooled. The semiconductor module and the temperature sensor module are then placed in contact with the cooling device. The temperature sensor located in the temperature sensor module outputs a detection signal corresponding to a temperature of the cooling medium.

The inventors are then considering making it possible to detect abnormalities in the temperature sensor provided in the temperature sensor module in such electronic devices. In this case, for example, a temperature sensor could also be mounted in the semiconductor module, and the temperature of the cooling medium could be estimated from the temperature sensor in the semiconductor module and compared with the results detected by the temperature sensor in the temperature sensor module. However, in this configuration, the configuration for estimating the temperature of the cooling medium from the temperature sensor of the semiconductor module is easily complicated.

Therefore, the object of this embodiment is to provide an electronic device that is capable of detecting abnormalities of a temperature sensor in a simple manner.

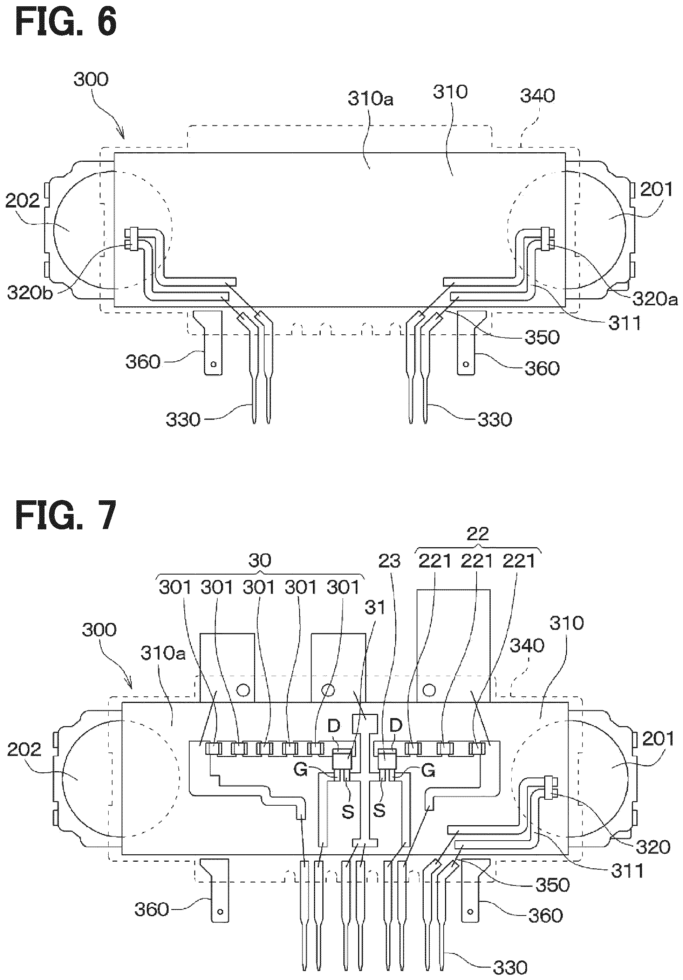

A temperature sensor module 300 of the present embodiment has two temperature sensors 320, as shown in FIG. 6. In the present embodiment, one of the two temperature sensors is a first temperature sensor 320a and the other of the two temperature sensors is a second temperature sensor 320b.

The first temperature sensor 320a is positioned at a position closer to the inlet pipe 201 than to the outlet pipe 202, and the second temperature sensor 320b is positioned at a position closer to the outlet pipe 202 than to the inlet pipe 201. More specifically, in the present embodiment, the first temperature sensor 320a is located in a printed circuit board 310 opposite the inlet pipe 201, and the second temperature sensor 320b is located in the printed circuit board 310 opposite the outlet pipe 202. Therefore, the first temperature sensor 320a outputs the temperature of the cooling medium before the semiconductor module 100 is thermally affected as a first detection signal, and the second temperature sensor 320b outputs the temperature of the cooling medium after the semiconductor module 100 is thermally affected as a second detection signal.

The controller 50 determines abnormalities of the first temperature sensor 320a and the second temperature sensor 320b based on the first detection signal input from the first temperature sensor 320a and the second detection signal input from the second temperature sensor 320b. In the present embodiment, a difference between the first detection signal detected by the first temperature sensor 320a when the electronic device is operating normally and the second detection signal detected by the second temperature sensor 320b when the electronic device is operating normally is derived in advance by experiment and stored in a storage unit. The controller 50 determines that the first temperature sensor 320a and the second temperature sensor 320b are normal when the difference between the first and second detection signals is within a threshold range, which is a pre-derived difference plus a predetermined range. The controller 50 determines that at least one of the first temperature sensor 320a and the second temperature sensor 320b is in an abnormal state such as malfunction when the difference between the first and second detection signals is outside the threshold range.

According to the present embodiment described above, the first temperature sensor 320a is positioned opposite to the inlet pipe 201, which has the same effects as the first embodiment described above.

In the present embodiment, the first temperature sensor 320a and the second temperature sensor 320b are located in the temperature sensor module 300. The controller 50 then determines the abnormalities of the first temperature sensor 320a and the second temperature sensor 320b based on the first detection signal from the first temperature sensor 320a and the second detection signal from the second temperature sensor 320b. As a result, the configuration is simplified compared to a case where a temperature sensor is placed in the semiconductor module 100, the temperature of the cooling medium is estimated from the detection result of this temperature sensor, and the estimated result is compared with the result detected by the temperature sensor in the temperature sensor module 300.

### Modification of Second Embodiment

A modification of a second embodiment will be described below. In the second embodiment above, the first temperature sensor 320a and the second temperature sensor 320b may each be provided on a portion of one surface 310a of the printed circuit board 310 that is opposite the inlet pipe 201. According to this, both the first temperature sensor 320a and the second temperature sensor 320b detect the temperature of the semiconductor module 100 before it is affected by heat. Therefore, the controller 50 only needs to set an error that can occur to a predetermined threshold range, further simplifying the configuration. The temperature sensor 320 may be provided with three or more multiples.

### Summary of Second Embodiment

The second embodiment is configured as described above. The configuration as in the second embodiment above is also useful when the temperature sensor 320 is located on the outlet pipe 202 side rather than a center between the inlet pipe 201 and the outlet pipe 202. Therefore, in summary, the following aspects are provided in the second embodiment.

### Aspect 1

An electronic device includes: a semiconductor module (100) having heat-generating elements (41a-46a) that generate heat when a current flows through them; a cooling device (200) having a flow channel through which a cooling medium to cool the semiconductor module flows; a temperature sensor module (300) having temperature sensors (320a, 320b) for detecting a temperature of the cooling medium; and a controller (50) that performs a predetermined processing. The cooling device has an inlet pipe (201) through which the cooling medium flows, an outlet pipe (202) through which the cooling medium flows out, and a connecting pipe (210) that connects the inlet pipe and the outlet pipe. The semiconductor module is arranged in contact with the connecting pipe. The temperature sensor module is arranged in contact with the connecting tube. The temperature sensor module is provided with temperature sensors. The controller determines an abnormality of the temperature sensor by comparing detection results detected by the temperature sensors.

### Aspect 2

The electronic device according to Aspect 1, wherein the temperature sensors are positioned on the side of the inlet pipe rather than the center between the inlet pipe and the outlet pipe.

### Third Embodiment

A third embodiment will be described. The third embodiment is a change in the location of a first discharge resistor 22, a first discharge switching element 23, a second discharge resistor 30, and a second discharge switching element 31, compared to the first embodiment. Other configurations are the same as those in the first embodiment, and thus, description thereof will be omitted here.

First, as described above, a temperature sensor module has been proposed, which includes a temperature sensor placed on a substrate and the substrate and temperature sensor sealed in a sealing member made of resin (see, for example, Non-Patent Literature 1).

By the way, the inventors are considering configuring an electronic device by placing a semiconductor module, in which heat-generating elements are placed on a substrate and sealed with a sealing member, in a cooling device, and also by placing the above temperature sensor module in the cooling device. More specifically, the cooling device is configured with a flow path through which a cooling medium such as cooling water passes so that the semiconductor module can be cooled. The semiconductor module and the temperature sensor module are then placed in contact with the cooling device. The temperature sensor located in the temperature sensor module outputs a detection signal corresponding to a temperature of the cooling medium. Furthermore, when such an electronic device is configured, the electronic device has a capacitor for smoothing a voltage of a power supply and a discharge resistor for discharging a charge of the capacitor.

In this case, for example, common chip resistors are used as discharge resistors. However, chip resistors have temperature characteristics, and although it depends on material that makes up the chip resistor, chip resistors have a steep drop in characteristics when the temperature exceeds a certain level. Therefore, when a discharge resistor is placed near a semiconductor module, it is necessary to select a configuration that does not degrade its characteristics even if it is heated by the semiconductor module, which may reduce selectivity of the discharge resistor.

Therefore, the object of the present embodiment is to provide an electronic device that is capable of improving selectivity of resistors for discharge.

In the temperature sensor module 300 of the present embodiment, the first discharge resistor 22, the first discharge switching element 23, the second discharge resistor 30, and the second discharge switching element 31 are located on one surface 310a of a printed circuit board 310, as shown in FIG. 7. FIG. 7 shows a diagram in which the first discharge resistor 22 has three chip resistors 221 and the second discharge resistor 30 has five chip resistors 301. However, the first discharge resistor 22 and the second discharge resistor 30 are actually arranged to correspond to the circuit configuration in FIG. 1. In FIG. 7, MOSFETs are shown in chip form as the first discharge switching element 23 and the second discharge switching element 31, with a gate shown as "G", a source as "S", and a drain as "D". In the present embodiment, the first discharge resistor 22, the first discharge switching element 23, the second discharge resistor 30, and the second discharge switching element 31 correspond to electronic components.

The temperature sensor module 300 is placed in contact with the cooling device 200 as described above. As a result, the temperature of each part is prevented from becoming higher than when the first discharge resistor 22, the first discharge switching element 23, the second discharge resistor 30, and the second discharge switching element 31 are arranged in a different state from that in which they are in contact with the cooling device 200. Therefore, the selectivity of the chip resistors that include the first discharge resistor 22 and the second discharge resistor 30, in particular, can be improved. The fact that the first discharge resistor 22, the first discharge switching element 23, the second discharge resistor 30, and the second discharge switching element 31 are arranged in a state different from that in which they are in contact with the cooling device 200 means, in other words, that these components are arranged outside the temperature sensor module 300 and are not in contact with the cooling device 200.

According to the present embodiment described above, the first temperature sensor 320a is positioned opposite to the inlet pipe 201, which has the same effects as the first embodiment described above.

In the present embodiment, the first discharge resistor 22 and the second discharge resistor 30 are located on one surface 310a of the printed circuit board 310. As a result, the temperature of each part is prevented from becoming higher than when the first discharge resistor 22, the first discharge switching element 23, the second discharge resistor 30, and the second discharge switching element 31 are arranged in a different state from that in which they are in contact with the cooling device 200. Therefore, the selectivity of the chip resistors that include the first discharge resistor 22 and the second discharge resistor 30, in particular, can be improved. Since the first discharge resistor 22 and the second discharge resistor 30 are arranged on one surface 310a of the printed circuit board 310, mounting members for arranging them are not necessary, thereby reducing the number of parts.

### Modification to Third Embodiment

A modification of the third embodiment will be described below. The above third embodiment describes an example in which the first discharge resistor 22, the first discharge switching element 23, the second discharge resistor 30, and the second discharge switching element 31 are placed on one surface 310a of the printed circuit board 310. However, not all, but some, of the first discharge resistor 22, the first discharge switching element 23, the second discharge resistor 30, and the second discharge switching element 31 may be placed on one surface 310a of the printed circuit board 310. Other electronic components may also be placed on one surface 310a of the printed circuit board 310. For example, an abnormality detection circuit according to a comparative example detects abnormalities in discharge resistors (see Patent Literature: JP6955951B). The electronic device of the present embodiment may also be provided with an abnormality detection circuit that detects an abnormality in each of the discharge resistors 22, 30, and this abnormality detection circuit may be placed on one surface 310a of the printed circuit board 310. According to this, since the abnormality detection circuit is also cooled by the cooling system, a temperature of the abnormality detection circuit can be prevented from becoming high. In this configuration, the abnormality detection circuit also corresponds to an electronic component.

### Summary of Third Embodiment

The third embodiment is configured as described above. The configuration as in the third embodiment above is also useful when the temperature sensor 320 is located on the outlet pipe 202 side rather than a center between the inlet pipe 201 and the outlet pipe 202. Therefore, in summary, the following aspects are provided in the third embodiment.

### Aspect 1

An electronic device includes: a semiconductor module (100) having heat-generating elements (41a-46a) that generate heat when a current flows through them; a cooling device (200) having a flow path through which a cooling medium flows to cool the semiconductor module; a temperature sensor module (300) having a temperature sensor (320) to detect a temperature of the cooling medium; and electronic components (22, 23, 30, 31) that perform the prescribed processing. The temperature sensor module is positioned in contact with the connecting pipe. The electronic components are located in the temperature sensor module together with the temperature sensor.

### Aspect 2

The electronic device according to Aspect 1 further includes: a capacitor (21, 29) placed between the heating element and the power supply (10); and a discharge resistor (22, 30) as the electronic component for discharging charge of the capacitor. The discharge resistor is located in the temperature sensor module.

### Aspect 3

The electronic device according to Aspect 1 or 2 further includes a discharge switching element (23, 31) as the electronic component that is positioned between the discharge resistor and the low-potential side of the power supply. The discharge switching element is located in the temperature sensor module.

### Fourth Embodiment

A fourth embodiment will be described. In the present embodiment, a configuration of a temperature sensor module 300 is changed from that in the first embodiment. Other configurations are the same as those in the first embodiment, and thus, description thereof will be omitted here.

First, as described above, a temperature sensor module has been proposed, which includes a temperature sensor placed on a substrate and the substrate and temperature sensor sealed in a sealing member made of resin (see, for example, Non-Patent Literature 1).

By the way, the inventors are considering configuring an electronic device by placing a semiconductor module, in which heat-generating elements are placed on a substrate and sealed with a sealing member, in a cooling device, and also by placing the above temperature sensor module in the cooling device. More specifically, the cooling device is configured with a flow path through which a cooling medium such as cooling water passes so that the semiconductor module can be cooled. The semiconductor module and the temperature sensor module are then placed in contact with the cooling device. The temperature sensor located in the temperature sensor module outputs a detection signal corresponding to a temperature of the cooling medium.

However, in such electronic devices, the inventors have found that detection accuracy of the temperature sensor may decrease depending on the configuration of the temperature sensor module.

Therefore, the object of the present embodiment is to provide an electronic device capable of reducing a decrease in detection accuracy of a temperature sensor.

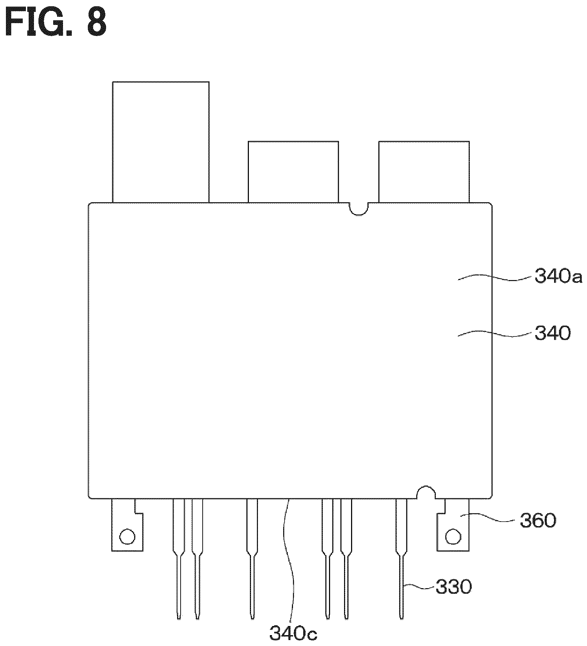

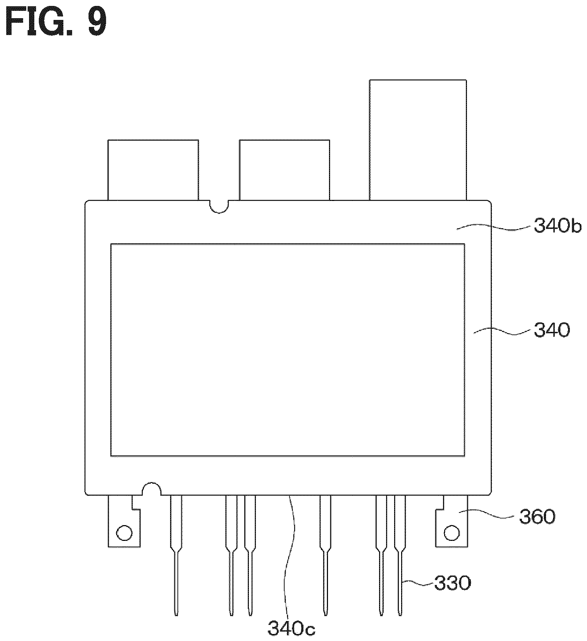

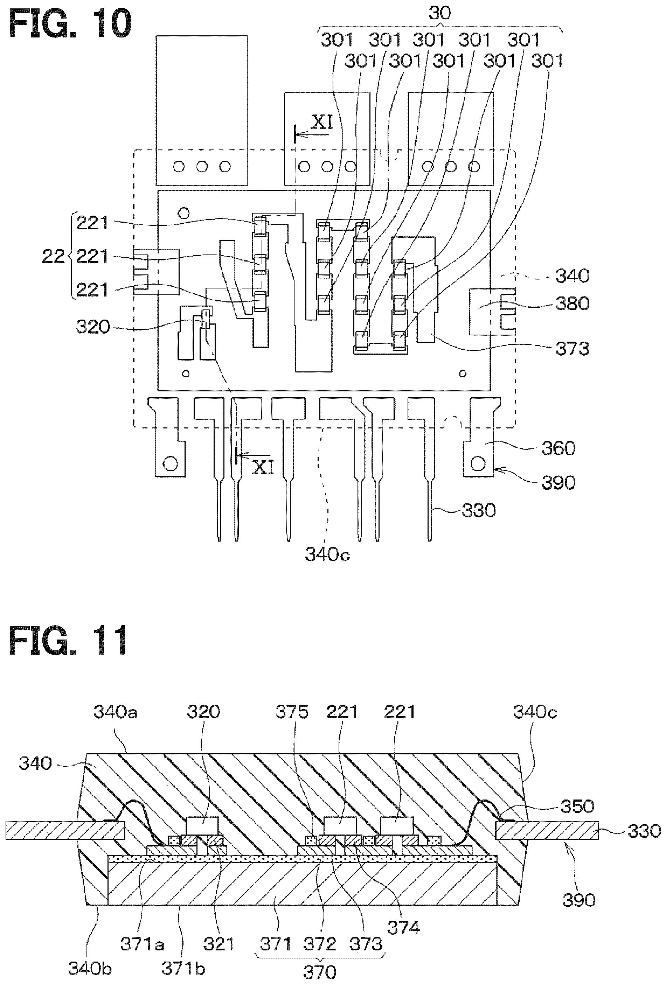

As shown in FIGS. 8 to 11, a temperature sensor module 300 of the present embodiment includes a mounting portion 370, a terminal 330, a positioning portion 360, a fixing portion 380, a temperature sensor 320, a first discharge resistor 22, a second discharge resistor 30, and the like integrated together. FIG. 8 is a plan view of a sealing member 340, which will be described later, viewed from one side 340a of the sealing member. FIG. 9 is a plan view of the sealing member 340 viewed from the other side 340b. FIG. 10 is a plan view of the sealing member 340 viewed from one side 340a, with the sealing member 340 indicated by a dotted line and a portion disposed within the sealing member 340 indicated by a solid line.

The mounting portion 370 is composed of a Cu plate, an Al plate, or the like, which has a higher thermal conductivity than the sealing member 340, and includes a heat-conductive member 371 having one side 371a and another side 371b opposite the one side 371a. The mounting portion 370 has an insulating film 372 disposed on one side 371a of the heat-conductive member 371, and a wiring pattern 373 disposed on the insulating film 372 and patterned to a predetermined shape.

A chip resistor 221, which constitutes the first discharge resistor 22, and a chip resistor 301, which constitutes the second discharge resistor 30, are arranged on the wiring pattern 373 via a bonding member 374 such as solder. FIG. 10 shows a diagram in which the first discharge resistor 22 has three chip resistors 221 and the second discharge resistor 30 has ten chip resistors 301. However, the first discharge resistor 22 and the second discharge resistor 30 are actually arranged to correspond to the circuit configuration in FIG. 1. An example in the present embodiment shows that the first discharge switching element 23 and the second discharge switching element 31 are located at different positions from those on the wiring pattern 373 of the mounting portion 370. However, the first discharge switching element 23 and the second discharge switching element 31 may be arranged on the wiring pattern 373 together with the first discharge resistor 22 and the second discharge resistor 30. The first discharge resistor 22 and the second discharge resistor 30 may be located in a different position than on the wiring pattern 373 of the mounting portion 370.

The temperature sensor 320 is placed on the wiring pattern 373 of the mounting portion 370 via a bonding member 321 such as solder. The temperature sensor 320 is thermally connected to the heat-conductive member 371 in the mounting portion 370. A solder resist 375 is placed on the wiring pattern 373 as appropriate. In FIG. 10, the solder resist 375 in FIG. 11 is omitted.

The terminal 330, the positioning portion 360, and the fixing portion 380 are composed of a lead frame 390 and are integrated by tie bars or other means before the sealing member 340 is formed. The terminal 330, the positioning portion 360, and the fixing portion 380 are each separated by removal of the tie bars after the sealing member 340 is formed.

The terminal 330 and the positioning portion 360 have the same function as in the first embodiment above. The terminal 330 is electrically connected to the wiring pattern 373 on one end via a bonding wire 350. The fixing portion 380 is a portion that fixes the mounting portion 370 to the lead frame 390, and is joined to the mounting portion 370 via a bonding member not shown.

The sealing member 340 is rectangular in shape, having one surface 340a, another surface 340b, and a lateral surface 340c connecting the one surface 340a to the other surface 340b. The sealing member 340 is configured to integrally seal the mounting portion 370 and the temperature sensor 320. More specifically, the sealing member 340 is configured so that the other end of the terminal 330 and one portion of the positioning portion 360 protrude from the lateral surface 340c, as in the first embodiment above. The sealing member 340 is configured so that the other surface 371b of the heat-conductive member 371 is exposed from the other surface 340b.

The temperature sensor module 300 of the present embodiment has the configurations as described above.

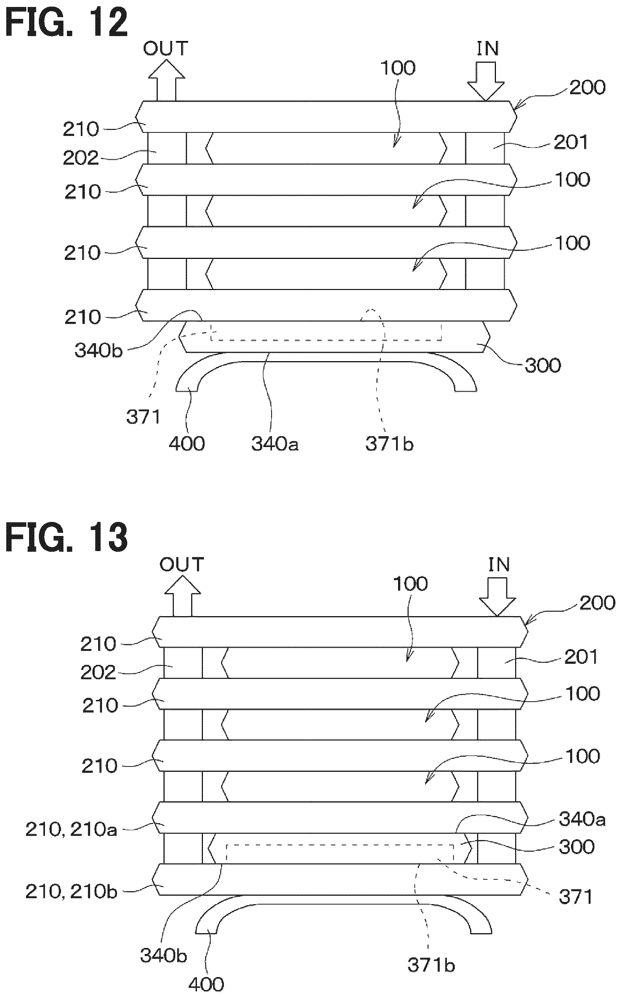

The temperature sensor module 300 is then provided to be in contact with an outermost connecting pipe 210 along an arrangement direction, as shown in FIG. 12. More specifically, the temperature sensor module 300 is arranged with the other surface 340b of the sealing member 340 facing the connecting pipe 210 so that the heat-conductive member 371 is in contact with the connecting pipe 210. As a result, the temperature of the cooling medium is more easily transferred to the temperature sensor 320 via the heat-conductive member 371, compared to a case where one surface 340a of the sealing member 340 is directed toward the connecting pipe 210 and the sealing member 340 is arranged to be in contact with the connecting pipe 210. As a result, the detection accuracy with respect to the temperature of the cooling medium can be improved. In the present embodiment, the connecting pipe 210 corresponds to a measured part.

According to the present embodiment described above, the heat-conductive member 371 is arranged in contact with the connecting pipe 210. As a result, the temperature of the cooling medium can be more easily transferred to the temperature sensor 320 via the heat-conductive member 371, thereby improving the detection accuracy.

### Fifth Embodiment

A fifth embodiment will be described. The fifth embodiment is a modification to the fourth embodiment in a way a temperature sensor module 300 is arranged. The remaining configurations are similar to those of the fourth embodiment and will thus not be described repeatedly.

In the present embodiment, as shown in FIG. 13, a cooling device 200 is provided with five connecting pipes 210 so that four gaps are configured. A semiconductor module 100 is placed in each adjacent gap along an arrangement direction, and a temperature sensor module 300 is placed in a remaining one gap in the arrangement direction. In other words, the temperature sensor module 300 is located between the connecting pipe 210, which is in contact with the semiconductor module 100, and the connecting pipe 210, which is not in contact with the semiconductor module 100. In two connecting pipes 210 arranged to sandwich the temperature sensor module 300, the connecting pipe 210 in contact with the semiconductor module 100 is also referred to as a first connecting pipe 210a, and the connecting pipe 210 not in contact with the semiconductor module 100 is also referred to as a second connecting pipe 210b.

The temperature sensor module 300 is arranged so that the other surface 371b of the heat-conductive member 371 is in contact with the second connecting pipe 210b and one surface 340a of the sealing member 340 is in contact with the first connecting pipe 210a.

According to the present embodiment described above, the temperature sensor module 300 is arranged so that the heat-conductive member 371 is in contact with the connecting pipe 210, and the same effects as in the fourth embodiment above can be obtained.

In the present embodiment, the heat-conductive member 371 is arranged to be in contact with the second connecting pipe 210b. As a result, it becomes easier to detect the temperature of the cooling medium, which is less affected by the temperature of the semiconductor module 100, thereby improving detection accuracy.

### Sixth Embodiment

A sixth embodiment will be described. In the sixth embodiment, a configuration of a temperature sensor module 300 is changed from that in the fourth embodiment. The remaining configurations are similar to those of the fourth embodiment and will thus not be described repeatedly.

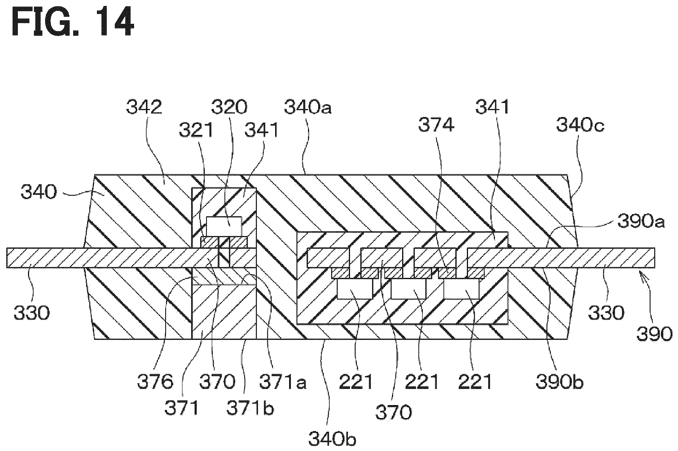

As shown in FIG. 14, the temperature sensor module 300 of the present embodiment also consists of a mounting portion 370, which is a portion of a lead frame 390. The mounting portion 370 of the present embodiment also functions as a wire and is divided accordingly. The temperature sensor 320 is located in a part that will become the mounting portion 370 on the lead frame 390 via the bonding member 321. The chip resistor 221, which forms the first discharge resistor 22 via the bonding member 374, is located on the lead frame 390. In the present embodiment, the temperature sensor 320 is arranged on one surface 390a of the lead frame 390, and the chip resistor 221 is arranged on the other surface 390b of the lead frame 390. However, the surface on which the temperature sensor 320 and the chip resistor 221 are located can be changed as needed. The chip resistor 301, which constitutes the second discharge resistor 30, is arranged accordingly in a separate cross section from FIG. 14.

A heat-conductive member 371 is arranged on a portion of the other surface 390b of the lead frame 390 that faces the temperature sensor 320 via a bonding member 376 such as an insulating sheet. Compared to the above fourth embodiment, the heat-conductive member 371 of the present embodiment is smaller in a planar direction than the heat-conductive member 371 of the above fourth embodiment.

The lead frame 390 and the temperature sensor 320 are integrally sealed by a sealing member 340. More specifically, the sealing member 340 is formed so that a portion of the lead frame 390 that is the terminal 330 protrudes from the lateral surface 340C. The sealing member 340 is formed so that the other surface 371b of the heat-conductive member 371 is exposed from the other surface 340b of the sealing member 340.

In the present embodiment, in order to simplify manufacturing processes, the sealing member 340 is configured with two primary mold members 341 and a secondary mold member 342. More specifically, one primary mold member 341 is formed to encapsulate the temperature sensor 320. The other primary mold member 341 is formed to encapsulate a chip resistor 221, which constitutes the first discharge resistor 22, and a chip resistor 301, which constitutes the second discharge resistor 30. The secondary mold member 342 is formed to encapsulate these primary mold member 341 and the heat-conductive member 371.

The heat-conductive member 371 is placed in contact with the connecting pipe 210 when the temperature sensor module 300 of the present embodiment is placed in the cooling device 200 as in the fourth embodiment above. In this case, the heat-conductive member 371 of the present embodiment is positioned opposite the temperature sensor 320, and compared to the above fourth embodiment, the portion exposed from the other surface 340b of the sealing member 340 is reduced. For this reason, the temperature sensor module 300 of the present embodiment may be arranged such that the temperature sensor 320 is located at a position closer to the inlet pipe 201 than to the outlet pipe 202, as in the first embodiment above. More particularly, the temperature sensor module 300 is preferably positioned so that the temperature sensor 320 is opposite the inlet pipe 201. As a result, it becomes easier to detect the temperature of the cooling medium before it is affected by the temperature of the semiconductor module 100, thereby improving detection accuracy.

The heat-conductive member 371 is placed in contact with the second connecting pipe 210b when the temperature sensor module 300 of the present embodiment is placed in the cooling device 200 as in the fifth embodiment above.

Even if the temperature sensor module 300 is configured as of the present embodiment described above, the same effects as in the fourth embodiment above can be obtained by arranging the heat-conductive member 371 so that it is in contact with the connecting pipe 210.

### Summary of Fourth through Sixth Embodiments

The fourth through sixth embodiments are configured as described above. The configuration as in the fourth through sixth embodiments above is also useful when the temperature sensor 320 is located on the outlet pipe 202 side rather than a center between the inlet pipe 201 and the outlet pipe 202. Therefore, summarizing the above fourth through sixth embodiments, it can be said that the temperature sensor module 300 or the electronic device has the following aspects.

### Aspect 1

A temperature sensor module includes a temperature sensor (320) that outputs a detection signal corresponding to a temperature. The module has a mounting portion (370) on which the temperature sensor is mounted. The module has a sealing member (340) encapsulates the temperature sensor and the mounting portion. The module also includes a heat-conductive member (371) that is thermally connected to the temperature sensor and is made of a material with higher thermal conductivity than the sealing member. The heat-conductive member is arranged within the sealing member so that a portion of the heat-conductive member is exposed from the sealing member. The heat-conductive member is designed to be in contact with a part to be measured.

### Aspect 2

The temperature sensor module according to Aspect 1, wherein the mounting portion has the heat-conductive member.

### Aspect 3

An electronic device includes: a semiconductor module (100) having a heat-generating element (41a to 46a) generating heat when an electric current flows through the heat-generating element; a cooling device (200) having a flow path through which a cooling medium flows to cool the semiconductor module; and the temperature sensor module (300) according to Aspect 1 or 2. The cooling device includes an inlet pipe (201) through which the cooling medium flows in, an outlet pipe (202) through which the cooling medium flows out, and a connecting pipe (210) connecting the inlet pipe to the outlet pipe. The semiconductor module is in contact with the connecting pipe. The heat-conductive member is in contact with the connecting pipe.

### Aspect 4

The electronic device according to Aspect 3, wherein the inlet pipe and the outlet pipe extend in a longitudinal direction, connecting pipes having the connecting pipe are arranged in rows with gaps in the longitudinal direction. The sealing member is in contact with a first connecting pipe (210a) of the connecting pipes which is in contact with the semiconductor module. The heat-conductive member is in contact with a second connecting pipe (210b) of the connecting pipes different from the first connecting pipe.

### Other Embodiments

Although the present disclosure has been described in accordance with the embodiments, it is understood that the present disclosure is not limited to such embodiments or structures. The present disclosure encompasses various modifications and variations within the scope of equivalents. In addition, various combinations and modes, and other combinations and modes including only one element, more elements, or less elements are also within the scope and idea of the present disclosure.

For example, in each of the above embodiments, the electronic device may have two or fewer semiconductor modules 100, or four or more semiconductor modules 100.

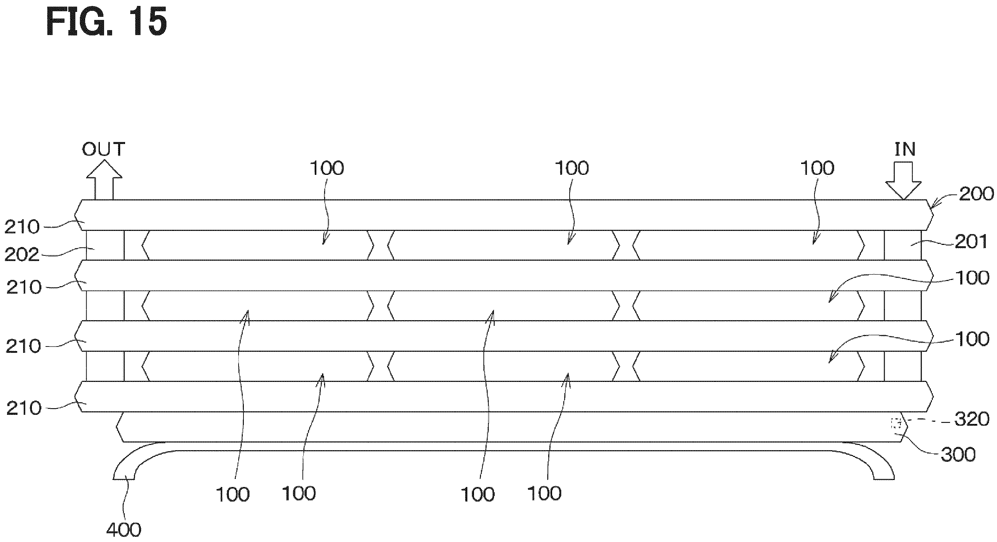

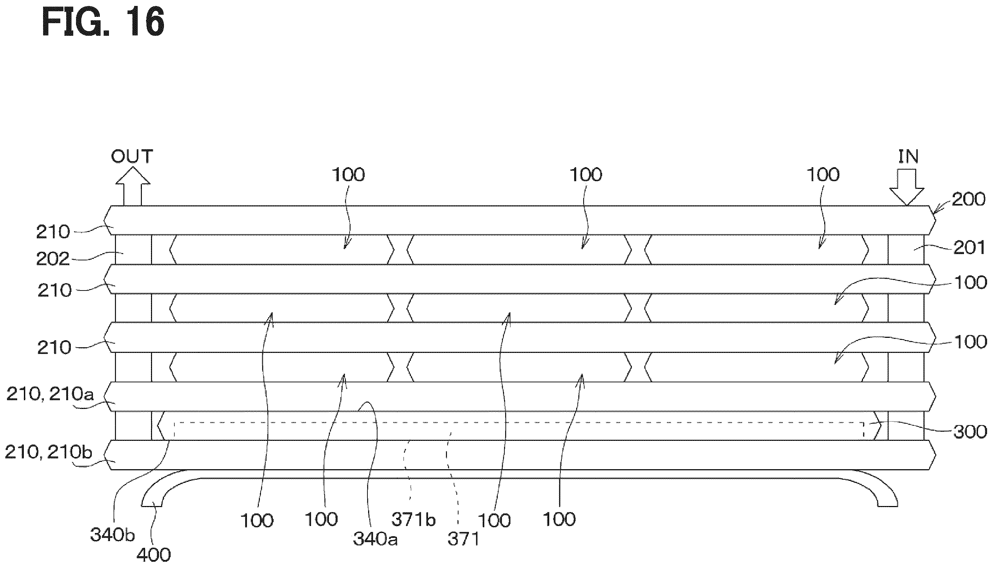

In each of the above embodiments, an example of placing one semiconductor module 100 between adjacent connecting pipes 210 along the arrangement direction has been described. However, the electronic device may have semiconductor modules 100 arranged between adjacent connecting pipes 210 along the arrangement direction, as shown in FIG. 15. However, in the first through third embodiments, the temperature sensor module 300 may be arranged so that the temperature sensor 320 is facing the inlet pipe 201. In the fifth embodiment above, the electronic device may have semiconductor modules 100 arranged between adjacent connecting pipes 210 along the arrangement direction, as shown in FIG. 16. Furthermore, although not specifically shown, in the fourth and sixth embodiments above, the electronic device may also have semiconductor modules 100 arranged between adjacent connecting pipes 210 along the arrangement direction. In FIGS. 15, 16, the temperature sensor module 300 is also enlarged along a face direction of the semiconductor module 100, but a size of the temperature sensor module 300 can be changed as needed.

And in each of the above embodiments, the semiconductor module 100 may not have switching elements 41a to 46a that constitute the 3-phase inverter circuit 40, but may have heat generating elements that constitute other circuits.

Further, in each of the above embodiments, the circuit configuration of the electronic device can be appropriately changed.

In addition, each of the above embodiments can be combined as appropriate. For example, the second embodiment above may be combined with the third through sixth embodiments above to provide two temperature sensors 320 while the first discharge resistor 22 and others are located in the temperature sensor module 300.

The controller and the method described in the present disclosure may be implemented by a special purpose computer which is configured with a memory and a processor programmed to execute one or more particular functions embodied in computer programs of the memory. Alternatively, the controller and the method described in the present disclosure may be implemented by a special purpose computer configured as a processor with one or more special purpose hardware logic circuits. Alternatively, the controller and the method described in the present disclosure may be implemented by one or more special purpose computer, which is configured as a combination of a processor and a memory, which are programmed to perform one or more functions, and a processor which is configured with one or more hardware logic circuits. The computer programs may be stored, as instructions to be executed by a computer, in a tangible non-transitory computer-readable medium.

## Claims

1. A temperature sensor module comprising:
a temperature sensor (320) configured to output a detection signal corresponding to a temperature;
a mounting portion (370) on which the temperature sensor is mounted;
a sealing member (340) encapsulating the temperature sensor and the mounting portion; and
a heat-conductive member (371) thermally connected to the temperature sensor, and made of a material having a higher thermal conductivity than the sealing member, wherein
the heat-conductive member is arranged in the sealing member such that a portion of the heat-conductive member is exposed from the sealing member, and
the heat-conductive member is to be in contact with a part to be measured.

2. The temperature sensor module according to claim 1, wherein
the mounting portion has the heat-conductive member.

3. An electronic device comprising:
a semiconductor module (100) having a heat-generating element (41a to 46a) generating heat when an electric current flows through the heat-generating element;
a cooling device (200) having a flow path through which a cooling medium flows to cool the semiconductor module; and
the temperature sensor module (300) according to claim 1 or 2, wherein
the cooling device includes an inlet pipe (201) through which the cooling medium flows in, an outlet pipe (202) through which the cooling medium flows out, and a connecting pipe (210) connecting the inlet pipe to the outlet pipe,
the semiconductor module is in contact with the connecting pipe, and
the heat-conductive member is in contact with the connecting pipe.

4. The electronic device according to claim 3, wherein
the inlet pipe and the outlet pipe extend in a longitudinal direction,
connecting pipes having the connecting pipe are arranged in rows with gaps in the longitudinal direction,
the sealing member is in contact with a first connecting pipe (210a) of the connecting pipes which is in contact with the semiconductor module, and
the heat-conductive member is in contact with a second connecting pipe (210b) of the connecting pipes different from the first connecting pipe.
